# EUROPEAN PATENT SPECIFICATION

(11) **EP 3 657 178 B1**
(45) Date of publication and mention of the grant of the patent: **14.07.2021**
(21) Application number: 19200999.1
(22) Date of filing: 02.10.2019
(51) Int. Cl.: G01P 15/125, G01P 15/18, G01P 15/08

(54) **ACCELEROMETER**
BESCHLEUNIGUNGSMESSER
ACCÉLÉROMÈTRE

(30) Priority: 16.11.2018 GB 201818712
(43) Date of publication of application: 27.05.2020
(73) Proprietor: Atlantic Inertial Systems Limited, Plymouth, Devon PL6 6DE (GB)
(72) Inventor: MALVERN, Alan, Plymouth, Devon PL6 6DE (GB)
(74) Representative: Dehns

(56) References cited:
- US-A1- 2006 201 249
- US-A1- 2010 005 884
- US-A1- 2010 109 102

## Description

### Technical Field

The present disclosure relates to accelerometers, particularly planar capacitive accelerometers for sensing out-of-plane accelerations.

### Background

Capacitive accelerometers are typically manufactured from silicon as micro-electromechanical systems (MEMS) devices. These small devices typically comprise a proof mass moveably mounted relative to a support or "substrate" using compliant flexures and sealed so that a gaseous medium trapped inside the device provides damping for the proof mass when it moves in a sensing direction in response to an acceleration being applied. In a capacitive accelerometer, there is typically provided a set of fixed electrodes attached to the substrate and a set of moveable electrodes attached to the proof mass, with the differential capacitance between the electrodes being measured so as to detect deflection of the proof mass. The resonant frequency of the MEMS device is defined by the mass of the proof mass and the positive spring constant of the compliant flexures.

For many applications, it is desirable to sense acceleration in the three orthogonal directions defined in Cartesian space, i.e. the x-axis, y-axis, and z-axis, such that accelerations can be measured in any direction in three-dimensional space. In order to achieve this, many inertial measurement units (IMUs), known in the art *per se*, use three accelerometer packages arranged orthogonally to one another such that there is an accelerometer provided for each axis. Each package contains one accelerometer together with the associated bond wires. However, having three separate accelerometer packages typically incurs additional cost and generally results in additional physical space being required in order to accommodate the three separate packages.

The Gemini® accelerometer available from Silicon Sensing® provides a dual-axis accelerometer in a single package that can sense accelerations in two axes, i.e. in-plane acceleration, which is suitable for many applications. However, in order to sense out-of-plane acceleration, an additional accelerometer is required as outlined above.

US 2010/005884 A1 describes a sensor that includes a proof mass suspended by a suspension beam, the suspension beam having a thickness less than a thickness of the proof mass.

US 2006/201249 A1 describes a comb drive device that includes a number of interdigitated comb fingers, some of which have a reduced thickness along at least a portion of their length relative to other comb fingers.

US 2010/109102 A1 describes a method for fabricating a micro electromechanical device includes providing a first substrate including control circuitry, where the method includes thinning a second substrate, bonded to the first substrate, to a predetermined thickness and forming a plurality of trenches in the second substrate.

Conventional three-axis accelerometers therefore typically require that at least two accelerometer packages are used, where one accelerometer package is placed 'on its side' next to another accelerometer package to provide sensing in all three orthogonal directions. At least some preferred examples of the present disclosure seek to address this problem.

### Summary of the Invention

According to a first aspect of this disclosure there is provided an accelerometer comprising:
a substantially planar proof mass mounted to a fixed substrate by a support, said proof mass being connected to the support by a compliant flexure so as to be linearly moveable in an out-of-plane sensing direction in response to an applied acceleration;
the proof mass comprising first and second sets of moveable capacitive electrode fingers extending from the proof mass substantially perpendicular to the out-of-plane sensing direction in a first in-plane direction and laterally spaced in a second in-plane direction perpendicular to the out-of-plane sensing direction; and
first and second fixed capacitor electrodes mounted to the fixed substrate, the first fixed capacitor electrode comprising a first set of fixed capacitive electrode fingers and the second fixed capacitor electrode comprising a second set of fixed capacitive electrode fingers; wherein the first and second sets of fixed capacitive electrode fingers extend in the first in-plane sensing direction and are laterally spaced in the second in-plane sensing direction;
wherein the first set of fixed capacitive electrode fingers is arranged to interdigitate with the first set of moveable capacitive electrode fingers of the proof mass and the second set of fixed capacitive electrode fingers is arranged to interdigitate with the second set of moveable capacitive electrode fingers of the proof mass;
wherein the first set of fixed capacitive electrode fingers has a thickness less than a thickness of the first set of moveable capacitive electrode fingers; and
wherein the second set of fixed capacitive electrode fingers has a thickness greater than a thickness of the second set of moveable capacitive electrode fingers.

It has been appreciated that, in use, each of the adjacent pairs of interdigitated fingers will have an electric field between their opposing faces. As the fingers in each set interdigitate, the degree of 'overlap' between the opposing faces of the thinner and thicker fingers will determine the electric field, and thus the capacitance, between the interdigitated fingers. As the accelerometer accelerates in the out-of-plane direction, the moveable fingers in each interdigitated set will move relative to the corresponding fixed fingers in that set, either 'upwards' or 'downwards' out-of-plane with respect to the substantially planar proof mass.

Due to the moveable fingers of one set being thinned and the fixed fingers of the other set being thinned, the capacitance of one set of interdigitated fingers will increase while the capacitance of the other set of interdigitated fingers will decrease for an acceleration in a particular direction (with the increase and decrease in capacitance of each set being reversed for an acceleration in the opposite direction). In general, when the moveable fingers move upwards or downwards in response to an out-of-plane acceleration, the degree of overlap between the opposing faces of the fixed and moveable fingers will vary, which will vary the electric field. As this overlap varies, the capacitance between adjacent fixed and moveable fingers will also vary. Specifically, as the amount of overlap increases, the capacitance increases.

Thus it will be appreciated by those skilled in the art that the present disclosure provides an accelerometer that may sense an applied acceleration out-of-plane with respect to the proof mass (i.e. an acceleration perpendicular to the plane of the proof mass). Advantageously, the z-axis accelerometer is planar and so may be manufactured within a single accelerometer package together with an x-axis and/or y-axis accelerometer, and preferably both so as to form a single 3-axis accelerometer package, avoiding the need to have multiple accelerometer packages arranged orthogonally to one another. In such an arrangement all three proof masses of the three accelerometers are in the same plane and could even be formed from the same wafer.

In accordance with this first aspect of the disclosure, the accelerometer has two pairs of interdigitated finger sets. One interdigitated finger set has the fixed fingers thinner than the corresponding moveable fingers with which they interdigitate, while in the other interdigitated finger set the moveable fingers are thinner than the fixed fingers.

It has been appreciated that by having relatively thinner moveable fingers in one interdigitated set and relatively thinner fixed fingers in the other interdigitated set, a positive g acceleration will, for example, cause an increase in capacitance between fingers in the interdigitated set with thinner moveable fingers and a decrease in capacitance between fingers in the other interdigitated set with thinner fixed fingers. Conversely, a negative g acceleration will cause a decrease in capacitance between fingers in the interdigitated set with thinner moveable fingers and an increase in capacitance between fingers in the other interdigitated set with thinner fixed fingers. The differential capacitance between the two interdigitated sets is a substantially linear measure of the applied out-of-plane acceleration.

The Applicant has appreciated that the above advantages may be obtained with appropriate thicknesses of each of the sets of fingers. However, in some examples, the thickness of the first set of moveable capacitive electrode fingers is substantially equal to a thickness of the proof mass. In some potentially overlapping examples, the thickness of the second set of fixed capacitive electrode fingers is substantially equal to a thickness of the proof mass. By using the full thickness of the proof mass for the thicker fingers, the difference in thickness between the thinner fingers and the thicker fingers can be maximised for a given thickness of the thinner fingers. This is particularly advantageous where the degree of thinning that it is possible to achieve is a limiting factor.

The compliant flexures and the thinned fingers may have different thicknesses to each other, however in at least some examples the thickness of the first set of fixed capacitive electrode fingers is substantially equal to a thickness of the flexure(s). In a set of potentially overlapping examples, the thickness of the second set of moveable capacitive electrode fingers is substantially equal to the thickness of the flexure(s).

The thickness of the flexure(s) may determine the out-of-plane resonance frequency which may, by way of example only, be set to be 2-3 kHz, which may give a typical g range of ±30 g. This may be achieved during the manufacturing process by using a back etch for both the electrodes and the flexures. If the flexures are too thin they may be too fragile, so a typical residual thickness may be 20-40 microns, compared to the thickness of the silicon substrate (i.e. the wafer) which may be 100-150 microns. This same thickness (20-40 µm) also works well for the thinned fingers and therefore advantageously a single back etch process can be used for both the flexure(s) and the thinned fingers.

There are also a number of device geometries to which the present disclosure could be readily applied, particularly with regard to the configuration of the moveable proof mass. In some examples the proof mass may take the form of a moveable frame that encloses the first and second sets of moveable capacitive electrode fingers and the first and second sets of fixed capacitive electrode fingers. The moveable capacitive electrode fingers may be arranged symmetrically inside the frame of the proof mass. The frame may be a rectangular frame, but may be of a different shape. In other examples, the proof mass may have an outwardly projecting form and may be located inwardly of the fixed capacitive electrode fingers.

In some examples, the proof mass is mounted to the fixed substrate by a plurality of supports, the proof mass being connected to the supports by a plurality of compliant flexures. Each support may, at least in some examples, be connected to the fixed substrate. This may be achieved, for example, by anodically bonding the support to the fixed substrate as outlined in further detail hereinbelow.

The fixed substrate may, at least in some examples, comprise a glass layer. In a preferred set of such examples, the proof mass is situated between a lower glass layer and an upper glass layer, wherein the lower and upper glass layers preferably form a hermetically sealed container in which the proof mass is located. An outer peripheral portion of the accelerometer (e.g. a surrounding part of the sensing layer that includes the proof mass, which is typically a silicon sensing layer) may, in some examples, surround the proof mass and be in communication with the upper and lower glass layers so as to form the hermetically sealed container. Hermetically sealing the container may advantageously prevent the ingress of moisture and/or particulates. The hermetically sealed contained may, in some examples, be backfilled with a gas that provides damping.

In some examples, each of the respective gaps between the fixed and moveable capacitive electrode fingers is substantially equal. In accordance with such examples, there is substantially no in-plane 'offset' between the interdigitated fingers. This results in the accelerometer being substantially insensitive to in-plane acceleration.

In some examples, the accelerometer further comprises a pulse width modulation (PWM) generator arranged to generate in-phase and anti-phase PWM drive signals with a drive frequency, wherein said in-phase and anti-phase PWM drive signals are applied to the first and second fixed capacitor electrodes respectively such that they are charged alternately.

In a set of potentially overlapping examples, the first and second sets of moveable capacitive electrode fingers further comprise electrical pick-off connections arranged to provide a pick-off signal, in use, for sensing an applied acceleration in the out-of-plane sensing direction. These electrical pick-off connections provide an output voltage (i.e. the pick-off signal) that may, in some examples, be supplied to a processing unit which can determine the applied amplitude. In some such examples, the accelerometer further comprises an output signal detector arranged to detect the pick-off signal from the accelerometer representing a displacement of the proof mass from a null position, wherein the null position is the position of the proof mass relative to the first and second fixed capacitor electrodes when no acceleration is applied.

Those skilled in the art will appreciate that the physical size and thicknesses of the accelerometer may be selected in accordance with the specific application in which the accelerometer is to be used. For example, a sensitivity of 20 nm/g may be desirable for a particular application, which may, for example, be achieved with a resonant frequency of e.g. 3 kHz. Such a resonant frequency may be achieved with a silicon wafer of thickness between approximately 100 µm and 150 µm and by thinning the relatively thinner fingers to approximately 30 µm with appropriate length of the flexure(s).

In some examples, the fixed and moveable capacitive electrode fingers are formed from a single wafer, preferably a single silicon wafer. This single wafer may be etched during the fabrication process in order to provide the structural features outlined hereinabove.

The electric field between the opposing faces of the interdigitated capacitive electrode fingers may also include an associated 'fringing field' at its periphery, i.e. a peripheral part of the electric field that extends beyond the physical boundaries of the opposing faces of the adjacent interdigitated fingers. As such, while the amount of physical 'overlap' between the opposing faces in the null position may be the same as when the thinned finger is positioned further into the volume of space extending from the opposing face of the thicker finger under acceleration (i.e. because the entire face of the thinner finger is 'within' the volume of space extending from the face of the thicker finger in both cases), there is a larger overlap from the point of view of the electric field when the thinned finger is positioned further into said volume because less of the fringing field extends beyond that volume than when the proof mass is in the null position.

The relative heights of the fixed and moveable capacitive electrode fingers need not be the same. Providing that changes in position of the proof mass in the out-of-plane sensing direction result in a change in capacitance (e.g. due to the influence of the fringing field as outlined above), the applied out-of-plane acceleration may be determined. However, in some examples an upper surface of the fixed capacitive electrode fingers is substantially coplanar with an upper surface of the moveable capacitive electrode fingers when the proof mass is in a null position, wherein the null position is the position of the proof mass relative to the first and second fixed capacitor electrodes when no acceleration is applied. This may, at least in some examples, advantageously avoid the need for the thinning of the fingers to be achieved by etching the wafer from both the front and from the back. In other words, the fingers may all be formed from a single wafer with the thinned fingers being formed by blind etching from one side, thus leaving the other side of all fingers coplanar in the null position.

The accelerometer may be operated in open loop (in which the proof mass is allowed to move under an acceleration) or it may be operated in closed loop (in which a restorative force is applied to the proof mass to return it to its null position under acceleration).

According to a second aspect of this disclosure there is provided a three-axis accelerometer comprising first, second, and third accelerometers all integrated within a single hermetic package, wherein:
the first accelerometer is arranged to measure an applied acceleration in a first accelerometer direction, and the second accelerometer is arranged to measure an applied acceleration in a second accelerometer direction orthogonal to the first accelerometer direction; and
the third accelerometer is arranged to measure an applied acceleration in an out-of-plane sensing direction orthogonal to the first and second accelerometer directions, the third accelerometer comprising:
   a substantially planar proof mass mounted to a fixed substrate by a support, said proof mass being connected to the support by a compliant flexure so as to be linearly moveable in the out-of-plane sensing direction in response to an applied acceleration;
   the proof mass comprising first and second sets of moveable capacitive electrode fingers extending in a first in-plane direction and laterally spaced in a second in-plane direction, said first and second in-plane directions being orthogonal to the out-of-plane sensing direction; and
   first and second fixed capacitor electrodes mounted to the fixed substrate, the first fixed capacitor electrode comprising a first set of fixed capacitive electrode fingers and the second fixed capacitor electrode comprising a second set of fixed capacitive electrode fingers; wherein the first and second sets of fixed capacitive electrode fingers extend in the first in-plane sensing direction and are laterally spaced in the second in-plane sensing direction;
   wherein the first set of fixed capacitive electrode fingers is arranged to interdigitate with the first set of moveable capacitive electrode fingers of the proof mass and the second set of fixed capacitive electrode fingers is arranged to interdigitate with the second set of moveable capacitive electrode fingers of the proof mass;
   wherein the first set of fixed capacitive electrode fingers has a thickness less than a thickness of the first set of moveable capacitive electrode fingers; and
   wherein the second set of fixed capacitive electrode fingers has a thickness greater than a thickness of the second set of moveable capacitive electrode fingers.

According to a third aspect of this disclosure there is provided an inertial measurement unit comprising a three-axis accelerometer in accordance with the second aspect of this disclosure, said inertial measurement unit further comprising first, second, and third gyroscopes each arranged to measure an angular rate with respect to first, second, and third gyroscope sensing directions respectively.

The preferred and optional features described hereinabove in relation to the first aspect apply equally to the second and third aspects.

Each individual accelerometer (and, where appropriate, gyroscope), may each individually comprise a hermetically sealed container. In some potentially overlapping examples, the three-axis accelerometer (and/or the inertial measurement unit as appropriate) comprises a hermetically sealed container containing the first, second, and third accelerometers (and, optionally, the first, second, and third gyroscopes).

Where both accelerometers and gyroscopes are provided, for example in an inertial measurement unit, the accelerometers may be hermetically sealed separately to the gyroscopes, and then the hermetically sealed containers of the accelerometers and gyroscopes may be further sealed within an IMU-level hermetically sealed container. Alternatively, the accelerometers and gyroscopes may be hermetically sealed within a single, common container.

According to a fourth aspect of this disclosure there is provided a method of producing an accelerometer for sensing accelerations in an out-of-plane sensing direction, the method comprising:
performing a blind etching process on a first surface of a silicon substrate;
anodically bonding the support to a first surface of a lower glass layer;
performing a full depth etching process on a second surface of the silicon substrate, said blind etching and full depth etching processes defining a substantially planar proof mass connected to a support by a compliant flexure, the proof mass comprising first and second sets of moveable capacitive electrode fingers extending from the proof mass substantially perpendicular to the out-of-plane sensing direction in a first in-plane direction and laterally spaced in a second in-plane direction perpendicular to the out-of-plane sensing direction; and
anodically bonding the second surface of the silicon substrate to an upper glass layer, wherein the upper glass layer and lower glass layer form a hermetically sealed container;
wherein the blind etching process comprises:
   etching the first set of fixed capacitive electrode fingers such that said first set of fixed capacitive electrode fingers has a thickness less than a thickness of the first set of moveable capacitive electrode fingers; and
   etching the second set of fixed capacitive electrode fingers such that said second set of fixed capacitive electrode fingers has a thickness greater than a thickness of the second set of moveable capacitive electrode fingers.

Those skilled in the art will appreciate that a 'blind' etching process involves etching away material without fully cutting through the material, i.e. the etch does not stop at another material but instead stops part-way through the material being etched.

Conversely, a full depth or 'through' etching process involves etching through the material to the other side, thus making a hole through the material being etched.

In some examples, the first set of moveable capacitive electrode fingers are not thinned such that the thickness of the first set of moveable capacitive electrode fingers is substantially equal to a thickness of the proof mass. In a potentially overlapping set of embodiments, the second set of fixed capacitive electrode fingers are not thinned such that the thickness of the second set of fixed capacitive electrode fingers is substantially equal to a thickness of the proof mass. As explained previously, by using the full thickness of the proof mass for the thicker fingers, the difference in thickness between the thinner fingers and the thicker fingers can be maximised for a given thickness of the thinner fingers.

In some examples, the method comprises thinning a portion of the first surface of a lower glass layer before anodically bonding the support to the first surface of the lower glass layer. By 'pre-cavitating' the lower glass layer, additional physical space is provided for the proof mass to move into when an acceleration is applied that causes the proof mass to move out-of-plane toward the lower glass layer.

In some potentially overlapping examples, the method comprises thinning a portion of the first surface of the upper glass layer before anodically bonding it to the silicon substrate. Again, by 'pre-cavitating' the upper glass layer, additional physical space is provided for the proof mass to move into when an acceleration is applied that causes the proof mass to move out-of-plane toward the upper glass layer. Furthermore, pre-cavitating the upper glass layer may avoid damage to the accelerometer structure which may arise during the anodic bonding process, e.g. due to high voltages being applied to the structure that may cause the structure to snap if it is too close to the upper glass layer.

In some examples, the method comprises providing electrical pick-off connections on the upper glass layer that connect to the silicon substrate through the downhole vias, said electrical pick-off connections being arranged to provide an output voltage, in use, for sensing an applied acceleration in the out-of-plane sensing direction.

In some examples, the method comprises performing an etching process on an exterior surface of the upper glass layer to provide one or more downhole vias.

In some examples, the blind etching process further comprises etching the support to reduce a thickness of said support. Those skilled in the art will appreciate that the thickness of the support may at least partially determine the out-of-plane resonant frequency of the accelerometer. This thinning step may, in accordance with such examples, advantageously be carried out at the same time as the thinning of the first set of fixed capacitive electrode fingers and the second set of moveable capacitive electrode fingers.

Those skilled in the art will appreciate that, typically, the wafer needs to be reasonably robust because the back etching process occurs before the anodic bonding, and so it is preferred that the silicon substrate wafer be handleable on its own. In some examples, the silicon substrate is temporarily attached to a handle wafer to give support during the back etching process. An exemplary handle wafer comprises an additional silicon wafer temporarily bonded by a wax to the silicon substrate wafer.

### Brief Description of Drawings

Certain examples of the disclosure will now be described, by way of example only, with reference to the accompanying drawings in which:
Fig. 1 is a cross-sectional view of an accelerometer in accordance with an example of the present disclosure;
Fig. 2 is a top-down plan view of the silicon substrate layer of the accelerometer package of Fig. 1;
Figs. 3A-C are cross-sectional views of the lower capacitive electrode finger set of Fig. 2;
Figs. 4A-C are cross-sectional views of the upper capacitive electrode finger set of Fig. 2;
Fig. 5 is a block diagram of the accelerometer connected for open loop operation;
Figs. 6A-C are block diagrams illustrating the effect of the fringing fields between the capacitive electrode finger sets;
Figs. 7A-C are block diagrams illustrating the equipotential lines surrounding the fixed capacitive electrode fingers;
Fig. 8 is a block diagram of a three-axis accelerometer including the accelerometer of Fig. 1 in accordance with an example of the present disclosure; and
Fig. 9 is a block diagram of an inertial measurement unit including the accelerometer of Fig. 1 in accordance with another example of the present disclosure.

### Detailed Description

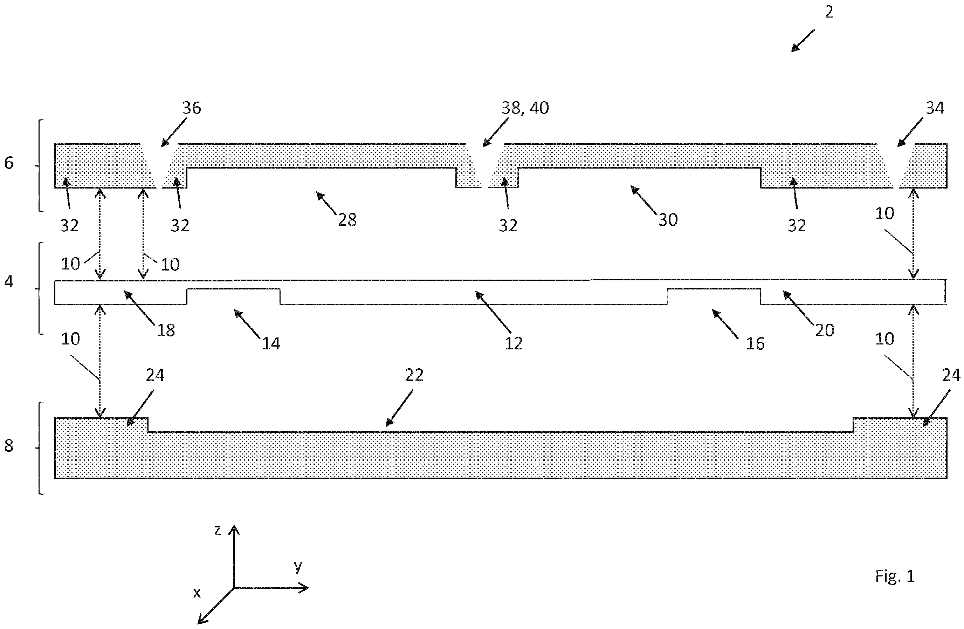

Fig. 1 is a cross-sectional view of an accelerometer 2 in accordance with an example of the present disclosure. The accelerometer 2 is constructed from a silicon substrate 4 which is 'sandwiched' between an upper glass substrate 6 and a lower glass substrate 8 (i.e. glass layer) to form a hermetic (i.e. air-tight) assembly. These layers 4, 6, 8 stack together when assembled as illustrated by the dashed arrows 10.

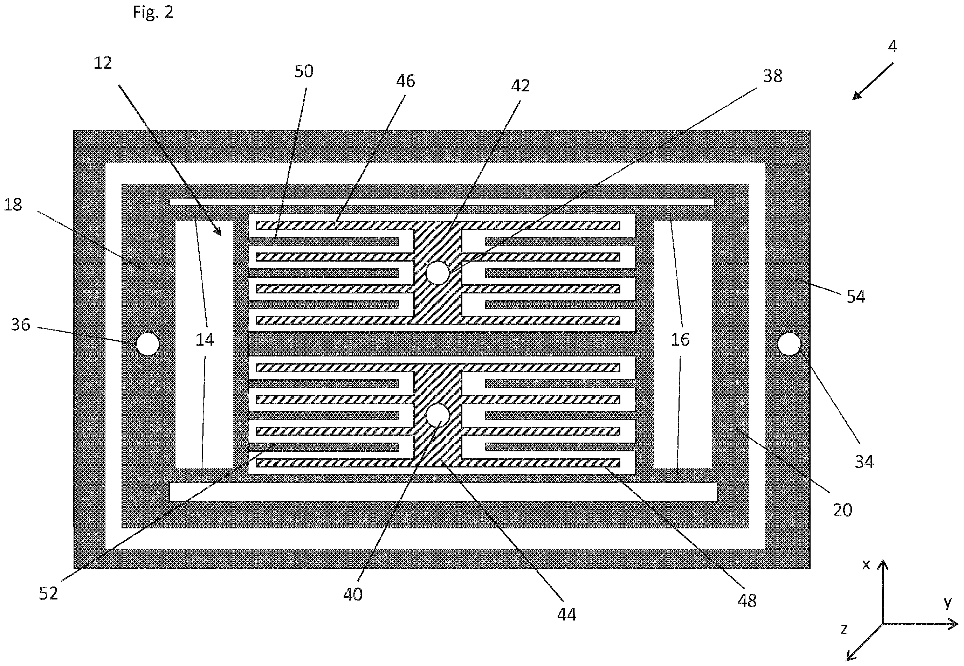

The 'back surface' of the silicon substrate 4 is 'blind etched' to define the thinned regions of a substantially planar proof mass 12 and compliant flexures 14, 16, which become such once a subsequent full depth etching process, explained below, takes place. These compliant flexures 14, 16 are substantially 'thinned' compared to the bulk silicon substrate 4 and provide a resilient connection between the proof mass 12 and a pair of supports 18, 20, where this thinning is achieved during the blind etching process. The structure and function of the proof mass 12 and compliant flexures 14, 16 is discussed in further detail below with respect to Fig. 2. The compliant flexures 14, 16 allow for motion of the proof mass 12 in the z-axis direction.

During the blind etching process, some of the capacitive electrode fingers are also thinned compared to the thickness of the bulk silicon substrate 4. This is explained in more detail with respect to Fig. 2 below.

Prior to assembly, the lower glass substrate 8 is subjected to a 'pre-cavitation' processing step in which the glass is thinned in a central portion 22. This pre-cavitation may be achieved using any suitable process known in the art *per se,* though one such process is wet etching. By wet etching (or using some other method) one surface of the lower glass substrate 8, the thickness of the central portion 22 is reduced to provide a cavity region in which the proof mass 12 can move once the accelerometer 2 is assembled.

The supports 18, 20, which form the 'roots' of the compliant flexures 14, 16, are anodically bonded to the non-cavitated peripheral portion of the lower glass substrate 8. The compliant flexures 14, 16 themselves are not anodically bonded and are free to allow movement of the proof mass 12. The supports 18, 20 therefore provide the point of contact between the silicon substrate 4 and the lower glass substrate 8.

A full depth (or 'through') etching process is carried out on the 'front surface' of the silicon substrate 4 to cut through the silicon, resulting in the proof mass 12 being connected to the surrounding silicon only via the compliant flexures 14, 16. This full depth etching process also separates the interdigitated capacitive electrode fingers from one another, as described below with respect to Fig. 2.

Similar to the lower glass substrate 8, the upper glass substrate 6 is also subjected to a pre-cavitation (e.g. wet etching) process step prior to assembly, e.g. to a depth of 15 µm, to produce the shaped upper glass substrate 6 in which several cavities 28, 30 are provided, resulting in several thicker support portions 32 of the glass. These cavities 28, 30 allow for motion of the proof mass 12 when the accelerometer 2 is subject to an applied acceleration that causes the proof mass 12 to move toward the upper glass substrate 6.

The support portions 32 of the upper glass substrate 6 are anodically bonded to the front (i.e. top) surface of the silicon substrate 4. Typically, the assembly 2 is backfilled with a gas such as air, neon, or argon, which provides damping in use.

A powder blasting process is then carried out on the uppermost surface of the upper glass substrate 6 in order to provide several downhole vias 34, 36, 38, 40. Note that there are two downhole vias 38, 40 located above the proof mass 12, one behind the other along the x-axis, as shown more clearly in Fig. 2.

Fig. 2 is a top-down plan view of the silicon substrate layer 4 of the accelerometer 2 of Fig. 1. The silicon substrate layer 4 has two centrally located fixed capacitive electrodes 42, 44 - an upper fixed capacitive electrode 42 and a lower fixed capacitive electrode 44. An upper set of fixed capacitive electrode fingers 46 extend from the upper fixed capacitive electrode 42 along the y-axis and are separated from one another along the x-axis, the x- and y-axes being orthogonal (i.e. perpendicular) to the z-axis, which is the sensing direction. A lower set of fixed capacitive electrode fingers 48 extend from the lower fixed capacitive electrode 44 along the y-axis and are separated from one another along the x-axis.

The proof mass 12 comprises an upper set of moving capacitive electrode fingers 50 and a lower set of moving capacitive electrode fingers 52. The upper set of moving capacitive electrode fingers 50 is arranged to interdigitate with the upper set of fixed capacitive electrode fingers 46, and the lower set of moving capacitive electrode fingers 52 is arranged to interdigitate with the lower set of fixed capacitive electrode fingers 48. As can be seen, the respective gaps between each finger and the two adjacent fingers are the same on both sides, i.e. the fingers have no substantial in-plane offset.

The supports 18, 20, which are anodically bonded to the lower glass substrate 8, are connected to the proof mass 12 via the thinned compliant flexures 14, 16. These compliant flexures 14, 16 allow the proof mass 12 to move out-of-plane in response to an applied out-of-plane acceleration (i.e. along the z-axis).

A peripheral portion 54 of the silicon substrate layer 4 provides a border around the device such that, once assembled, it forms a side-wall that, together with the upper and lower glass layers 6, 8, encloses the proof mass 12 in a hermetically sealed container. It will be appreciated that, the glass may be arranged to also enclose an x-axis and/or a y-axis accelerometer to form a three-axis accelerometer within a single hermetically sealed container. This peripheral portion 54 is, after all etching steps are complete, electrically isolated from the interior portion of the accelerometer.

A downhole via 34 provided on the upper glass substrate 6 gives an electrical connection to the peripheral portion 54, and specifically provides an electrical connection for electrical ground, such that the outer frame 54 of the silicon substrate layer 4 is grounded in use.

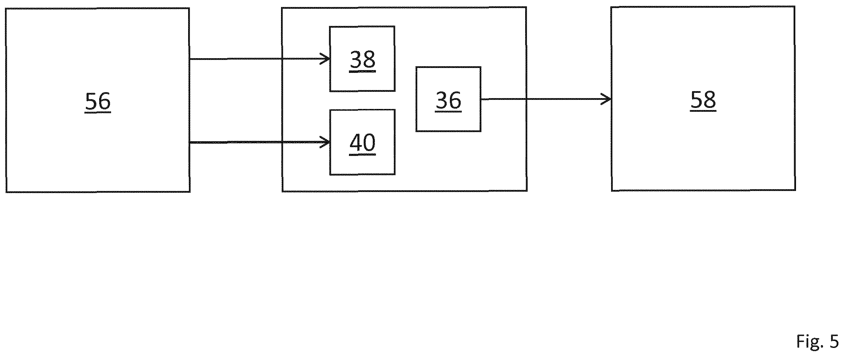

The other two downhole vias 38, 40 provide electrical connections to the upper fixed capacitive electrode 42 and lower fixed capacitive electrode 44 respectively. As shown in Fig. 5, these downhole vias 38, 40 are connected to a PWM generator 56 which provides in-phase and anti-phase PWM drive signals, as will be well understood by those skilled in the art.

A further downhole via 36 is provided on one of the supports 18 and provides an electrical connection to the silicon that includes the proof mass 12. As shown in Fig. 5, this downhole via 36 is connected to an output signal detector 58 which detects a pick-off signal from the accelerometer 2 which represents displacement of the proof mass 12 in the z-axis direction.

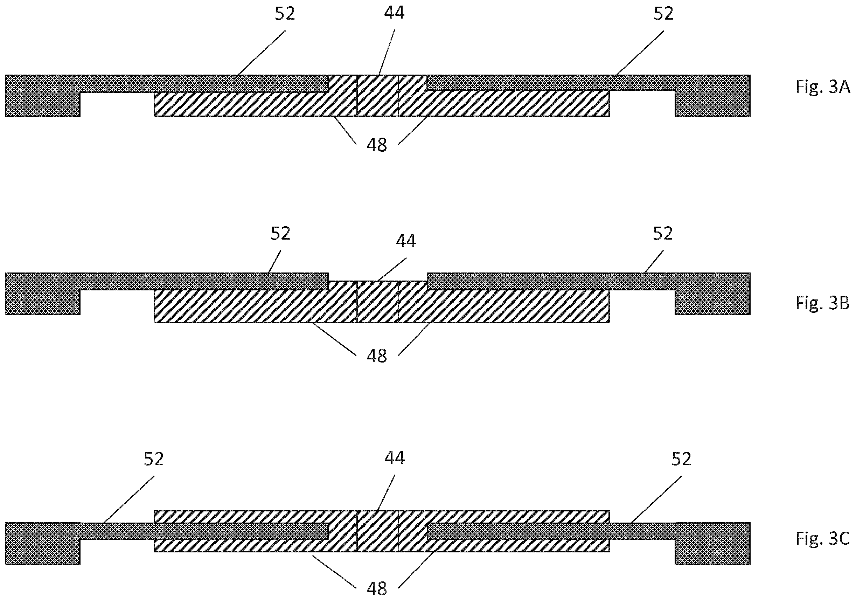

Figs. 3A-C are cross-sectional views of the lower capacitive electrode finger set of Fig. 2. On the lower set of interdigitated fingers, the lower set of fixed capacitive electrode fingers 48 are the full thickness of the silicon substrate 4 while the lower set of moveable capacitive electrode fingers 52 are thinned during the back-etching process, and so are thinner than the lower set of fixed capacitive electrode fingers 48.

Fig. 3A shows the lower capacitive electrode finger set when the accelerometer 2 is not experiencing any out-of-plane acceleration, i.e. in its null position, under a g force of zero. As can be seen, the top of the thinned lower moveable capacitive electrode fingers 52 lies substantially parallel with, and at the same height as, the top of the full-thickness lower fixed capacitive electrode fingers 48. Due to the lower moveable capacitive electrode fingers 52 being thinned, the bottom of the lower moveable capacitive electrode fingers 52 lies between the top and bottom of the lower fixed capacitive electrode fingers 48. This results in the opposing face of the lower moveable capacitive electrode fingers 52 being situated mostly within (i.e. overlapping with) the opposing face of the lower fixed capacitive electrode fingers 48.

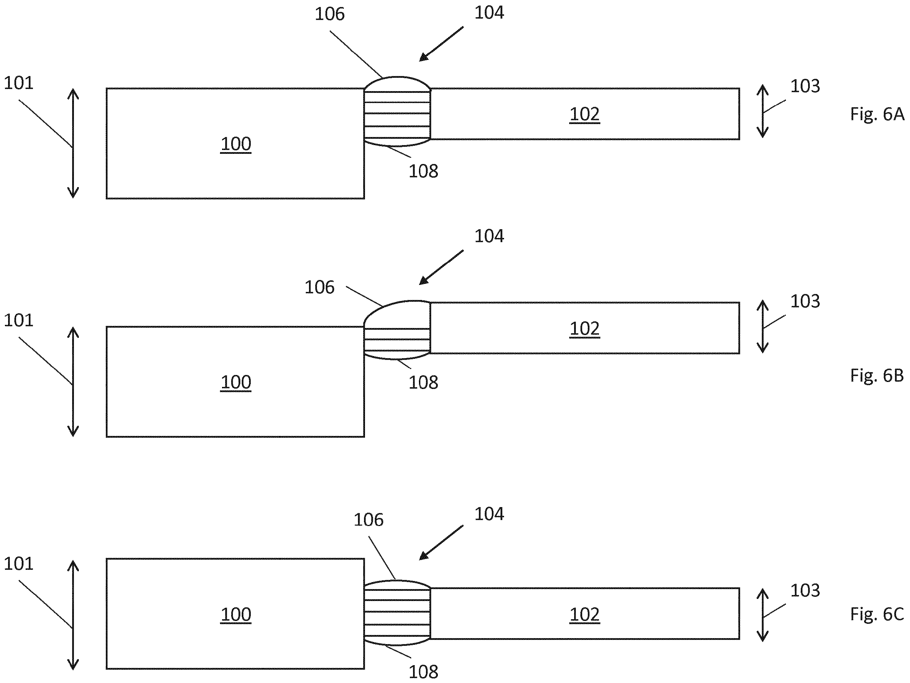

Fig. 3B shows the lower capacitive electrode finger set when the accelerometer 2 is experiencing an out-of-plane acceleration downwards along the z-axis, i.e. under a positive g force. As the accelerometer 2 accelerates downwards, the lower moveable capacitive electrode fingers 52 are displaced upwards relative to the lower fixed capacitive electrode fingers 48, such that there is less overlap between their opposing faces, thereby reducing the magnitude of the electric field due to the overlap and also reducing the influence of the fringing field. This results in a reduction in capacitance between the lower moveable capacitive electrode fingers 52 and the lower fixed capacitive electrode fingers 48. The effects of the fringing fields are explained with reference to Figs. 6A-C below.

Conversely, Fig. 3C shows the lower capacitive electrode finger set when the accelerometer 2 is experiencing an out-of-plane acceleration upwards along the z-axis, i.e. under a negative g force. As the accelerometer 2 accelerates upwards, the lower moveable capacitive electrode fingers 52 are displaced downwards relative to the lower fixed capacitive electrode fingers 48. Although there is no change in the perpendicular overlap between their opposing faces, this movement increases the influence of the fringing field and thereby increases the total electric field strength and therefore also the capacitance. This results in an increase in capacitance between the lower moveable capacitive electrode fingers 52 and the lower fixed capacitive electrode fingers 48.

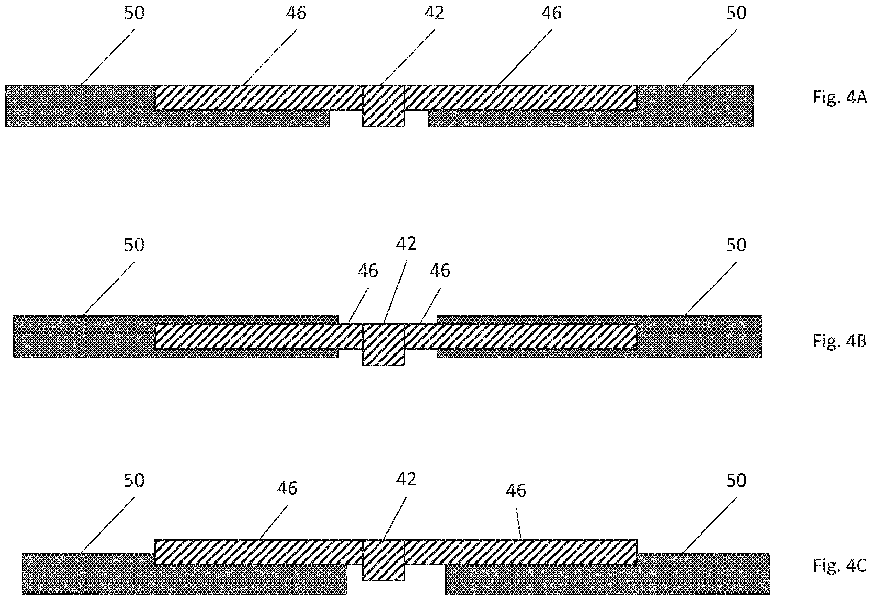

Figs. 4A-C are cross-sectional views of the upper capacitive electrode finger set of Fig. 2. On the upper set of interdigitated fingers, the upper set of moveable capacitive electrode fingers 50 are the full thickness of the silicon substrate 4 while the upper set of fixed capacitive electrode fingers 46 are thinned during the back-etching process, and so are thinner than the upper set of moveable capacitive electrode fingers 50.

Fig. 4A shows the upper capacitive electrode finger set when the accelerometer 2 is not experiencing any out-of-plane acceleration, i.e. in its null position, under a g force of zero. As can be seen, the top of the full-thickness upper moveable capacitive electrode fingers 50 lies substantially parallel with, and at the same height as, the top of the thinned upper fixed capacitive electrode fingers 46. Due to the upper fixed capacitive electrode fingers 46 being thinned, the bottom of the upper fixed capacitive electrode fingers 46 lies between the top and bottom of the upper moveable capacitive electrode fingers 50. This results in the opposing face of the upper fixed capacitive electrode fingers 46 being situated mostly within (i.e. overlapping with) the opposing face of the upper moveable capacitive electrode fingers 50.

Fig. 4B shows the upper capacitive electrode finger set when the accelerometer 2 is experiencing an out-of-plane acceleration downwards along the z-axis, i.e. under a positive g force. As the accelerometer 2 accelerates downwards, the upper moveable capacitive electrode fingers 50 are displaced upwards relative to the upper fixed capacitive electrode fingers 46. Although there is no change in the perpendicular overlap between their opposing faces, this movement increases the influence of the fringing field and thereby increases the total electric field strength and therefore also the capacitance. This results in an increase in capacitance between the upper moveable capacitive electrode fingers 50 and the upper fixed capacitive electrode fingers.

Conversely, Fig. 4C shows the upper capacitive electrode finger set when the accelerometer 2 is experiencing an out-of-plane acceleration upwards along the z-axis, i.e. under a negative g force. As the accelerometer 2 accelerates upwards, the upper moveable capacitive electrode fingers 50 are displaced downwards relative to the upper fixed capacitive electrode fingers 46, such that there is less overlap between their opposing faces, thereby reducing the magnitude of the electric field due to the overlap and also reducing the influence of the fringing field. This results in a reduction in capacitance between the upper moveable capacitive electrode fingers 50 and the upper fixed capacitive electrode fingers 46.

Therefore, under a positive g force, the capacitance between the interdigitated fingers 48, 52 in the lower set decreases and the capacitance between the interdigitated fingers 46, 50 in the upper set increases. Under a negative g force, the capacitance between the interdigitated fingers 48, 52 in the lower set increases and the capacitance between the interdigitated fingers 46, 50 in the upper set decreases. The differential capacitance between the upper and lower sets of interdigitated fingers is substantially linear with the out-of-plane acceleration being applied.

Figs. 6A-C are block diagrams illustrating the effect of the fringing fields between the capacitive electrode finger sets described above. It should be noted that these diagrams are merely illustrative and the effects of the fringing fields for a particular device according to the disclosure can be understood through simulation, e.g. using finite element modelling.

A thicker capacitive structure 100 having a thickness 101 is situated opposite a thinner capacitive structure 102 having a thickness 103 less than the thickness 101 of the thicker capacitive structure 100. One of these thicker and thinner capacitive structures 100, 102 is a moveable finger and the other capacitive structure 100, 102 is a fixed finger, however the diagram is not limited as to which way around these are, depending on which set of interdigitated capacitive electrode fingers apply.

Fig. 6A shows the capacitive structures 100, 102 in the null position, such that the top surfaces of each capacitive structure 100, 102 are coplanar with each other. An electric field 104 exists between the opposing faces of the capacitive structures 100, 102. At the periphery of the electric field is a fringing field 106, 108 that extends beyond the physical boundary of the thinner capacitive structure 102. For ease of reference, an 'upper' fringing field 106 and a 'lower' fringing field 108 are shown, though it will be appreciated that, in practice, the fringing field will extend from the entire periphery of the thinner capacitive structure 102. This fringing field contributes to the total electric field 104 between the capacitive structures 102 and thus, in turn, contributes to the capacitance between them.

Fig. 6B shows the capacitive structures 100, 102 when the thinner capacitive structure 102 has moved upwards relative to the thicker capacitive structure 100. As there is now less overlap between the opposing faces of the capacitive structures 100, 102, the perpendicular field and the influence of the upper portion of the fringing field 106 is reduced, thus causing a reduction in the total electric field 104 between the capacitive structures 102 and therefore the capacitance between them is reduced.

Fig. 6C shows the capacitive structures 100, 102 when the thinner capacitive structure 102 has moved downwards relative to the thicker capacitive structure 100. It will be appreciated that while the amount of 'physical overlap' between the opposing faces in Figs. 6A and 6C is the same in that the entire face of the thinner capacitive structure 102 is 'within' the volume of space extending from the face of the thicker capacitive structure 102 in both cases, there is a larger 'electrical overlap' from the point of view of the electric field in Fig. 6C than in Fig. 6A because less of the fringing field extends beyond that volume in Fig. 6C than in Fig. 6A.

With reference to Fig. 6C, as there is now more electrical overlap between the opposing faces of the capacitive structures 100, 102, the influence of the upper portion of the fringing field 106 is increased, thus causing an increase in the total electric field 104 between the capacitive structures 102 and therefore the capacitance between them is increased.

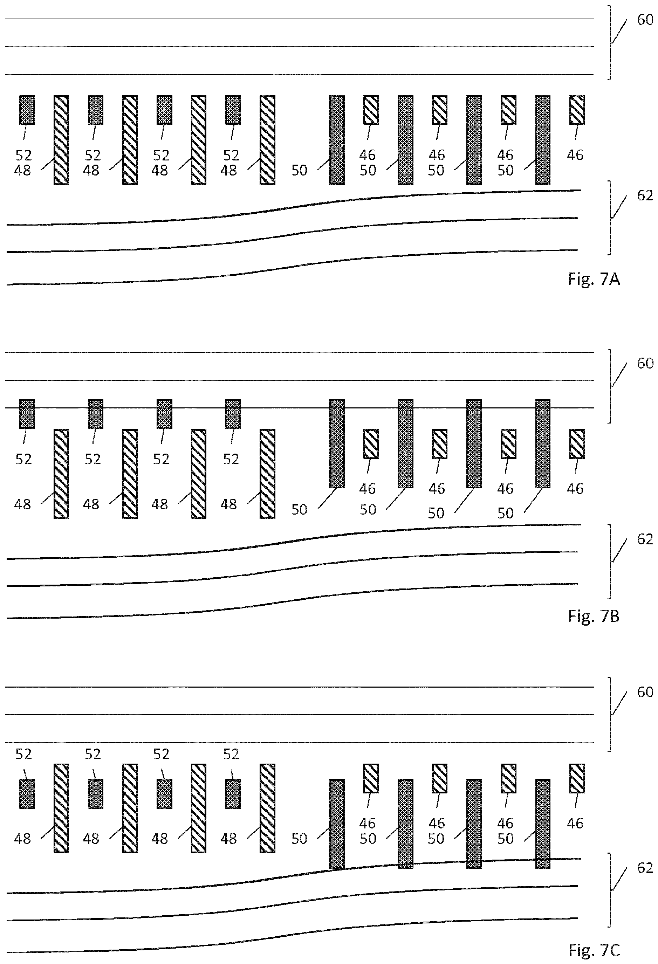

Figs. 7A-C are block diagrams illustrating the equipotential lines 60, 62 surrounding the fixed capacitive electrode fingers 46, 48. The thicker lower set of fixed capacitive electrode fingers 48, interdigitated with the thinned lower set of moveable capacitive electrode fingers 52, is shown on the left. The thinned upper set of fixed capacitive electrode fingers 46, interdigitated with the thicker upper set of moveable capacitive electrode fingers 50, is shown on the right.

In each of Figs. 7A-C, a fixed test voltage is applied to the fixed capacitive electrode fingers 46, 48, resulting in the equipotential lines 60, 62 that surround and are substantially centred around the fixed capacitive electrode fingers 46, 48. It can be seen that the equipotential lines 60 are substantially flat above the coplanar top surfaces of the fixed capacitive electrode fingers 46, 48. Conversely, the equipotential lines 62 below the bottom surfaces of the fixed capacitive electrode fingers 46, 48, which are at different heights due to the thinning process applied to the thinned set of fixed fingers 46, bend due to this difference in thicknesses. it will be appreciated that the equipotential lines 60, 62 would, in practice, completely surround all parts of the fixed fingers 46, 48 and would be continuous, however only a finite, discrete selection of equipotential lines 60, 62 are shown for ease of illustration.

Those skilled in the art will appreciate that each of the individual lines in the sets of equipotential lines 60, 62 represents a path along which the voltage which would be observed by a test charge if placed there would be equal. The magnitude of the voltage at each of these lines 60, 62 will typically decrease as the distance from the fixed capacitive electrode fingers 46, 48 increases.

Fig. 7A shows the thinned lower set of moveable capacitive electrode fingers 52 and the thicker upper set of moveable capacitive electrode fingers 50 in the null position, in which their top surfaces are coplanar with the top surfaces of the fixed capacitive electrode fingers 46, 48.

With reference to Fig. 7B and as described previously with reference to Figs. 3B and 4B, under an out-of-plane acceleration downwards along the z-axis, i.e. under a positive g force, the accelerometer 2 accelerates downwards and the lower moveable capacitive electrode fingers 52 are displaced upwards relative to the lower fixed capacitive electrode fingers 48 while the upper moveable capacitive electrode fingers 50 are also displaced upwards relative to the upper fixed capacitive electrode fingers 46. This results in the moveable capacitive electrode fingers 50, 52 moving upwards, further into the upper equipotential lines 60, i.e. into a region of lower voltage.

Conversely, with reference to Fig. 7C and as described previously with reference to Figs. 3C and 4C, under an out-of-plane acceleration upwards along the z-axis, i.e. under a negative g force, the accelerometer 2 accelerates upwards and the lower moveable capacitive electrode fingers 52 are displaced downwards relative to the lower fixed capacitive electrode fingers 48 while the upper moveable capacitive electrode fingers 50 are also displaced downwards relative to the upper fixed capacitive electrode fingers 46. This results in the moveable capacitive electrode fingers 50, 52 moving downwards, further into the lower equipotential lines 62, i.e. into a region of lower voltage.

As outlined above, the upper set of fixed capacitive electrode fingers 46 is thinned compared to the lower set of fixed capacitive electrode fingers 48 which causes the lower set of equipotential lines 62 to 'bend'. Accordingly, the change in voltage experienced by each of the different moveable electrode fingers 50, 52 in each set varies. This gives rise to a differential change in capacitance between the upper set of interdigitated electrode fingers 46, 50 compared to the lower set of interdigitated electrode fingers 48, 52, where this differential change in capacitance is a substantially linear measure of the applied out-of-plane acceleration.

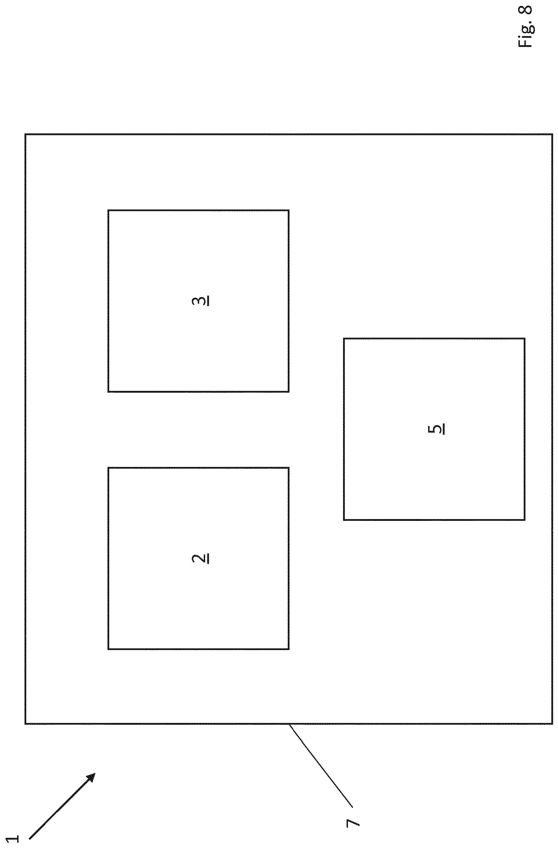

Fig. 8 is a block diagram of a three-axis accelerometer 1 including the accelerometer 2 of Fig. 1 in accordance with an example of the present disclosure. The z-axis accelerometer 2, together with an x-axis accelerometer 3 and a y-axis accelerometer 5, is located within a hermetically sealed container 7. Advantageously, all three accelerometers 2, 3, 5 are coplanar with one another (i.e. all their proof masses are coplanar). The x-axis accelerometer 3 and y-axis accelerometers may be discrete accelerometers, or may be a dual-axis accelerometer such as the Gemini® accelerometer available from Silicon Sensing®.

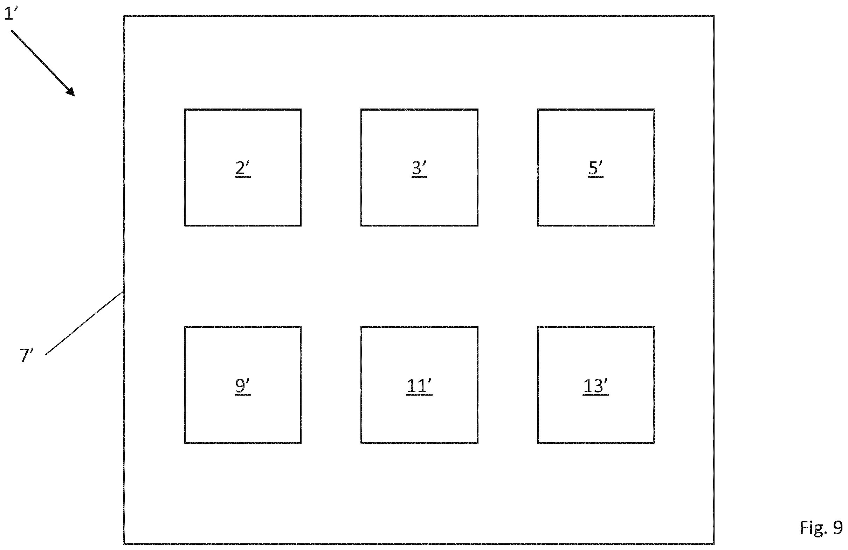

Fig. 9 is a block diagram of an inertial measurement unit 1' including the accelerometer of Fig. 1 in accordance with another example of the present disclosure, where like reference numerals indicate like components. The z-axis accelerometer 2', together with an x-axis accelerometer 3' and a y-axis accelerometer 5', is located within a hermetically sealed container 7'. Also located within the hermetically sealed container 7' are a z-axis gyroscope 9', an x-axis gyroscope 11', and a y-axis gyroscope 13', arranged to measure angular rates about the z-, x-, and y- axes respectively.

Again, the x-axis accelerometer 3 and y-axis accelerometers may be discrete accelerometers, or may be a dual-axis accelerometer such as the Gemini® accelerometer described above.

Thus it will be seen that the present disclosure provides an improved accelerometer that may sense an applied acceleration out-of-plane with respect to the proof mass. Advantageously, the z-axis accelerometer is planar and so may be manufactured within a single accelerometer package together with x-axis and y-axis accelerometers so as to form a single, planar 3-axis accelerometer package. It will be appreciated by those skilled in the art that the examples described above are merely exemplary and are not limiting on the scope of the invention.

## Claims

1. An accelerometer (2) comprising:
a substantially planar proof mass (12) mounted to a fixed substrate (4) by a support (18, 20), said proof mass (12) being connected to the support (18, 20) by a compliant flexure (14, 16) so as to be linearly moveable in an out-of-plane sensing direction in response to an applied acceleration;
the proof mass (12) comprising first and second sets of moveable capacitive electrode fingers (50, 52) extending from the proof mass (12) substantially perpendicular to the out-of-plane sensing direction in a first in-plane direction and laterally spaced in a second in-plane direction perpendicular to the out-of-plane sensing direction; and
first and second fixed capacitor electrodes (42, 44) mounted to the fixed substrate (4), the first fixed capacitor electrode (42) comprising a first set of fixed capacitive electrode fingers (46) and the second fixed capacitor electrode (44) comprising a second set of fixed capacitive electrode fingers (48); wherein the first and second sets of fixed capacitive electrode fingers (46, 48) extend in the first in-plane sensing direction and are laterally spaced in the second in-plane sensing direction;
wherein the first set of fixed capacitive electrode fingers (46) is arranged to interdigitate with the first set of moveable capacitive electrode fingers (50) of the proof mass (12) and the second set of fixed capacitive electrode fingers (48) is arranged to interdigitate with the second set of moveable capacitive electrode fingers (52) of the proof mass (12);
wherein the first set of fixed capacitive electrode fingers (46) has a thickness less than a thickness of the first set of moveable capacitive electrode fingers (50); and
wherein the second set of fixed capacitive electrode fingers (48) has a thickness greater than a thickness of the second set of moveable capacitive electrode fingers (52).

2. The accelerometer (2) as claimed in claim 1, wherein the thickness of the first set (50) and/or the second set (52) of moveable capacitive electrode fingers is substantially equal to a thickness of the proof mass (12).

3. The accelerometer (2) as claimed in claim 1 or 2, wherein the proof mass (12) comprises a moveable frame (54) that encloses the first and second sets of moveable capacitive electrode fingers (50, 52) and the first and second sets of fixed capacitive electrode fingers (46, 48).

4. The accelerometer (2) as claimed in any preceding claim, wherein the proof mass (12) is mounted to the fixed substrate (4) by a plurality of supports (18, 20), the proof mass (12) being connected to the supports (18, 20) by a plurality of compliant flexures (14, 16).

5. The accelerometer (2) as claimed in any preceding claim, wherein the proof mass (12) is situated between a lower glass layer (8) and an upper glass layer (6), wherein the lower and upper glass layers (6, 8) preferably form a hermetically sealed container in which the proof mass (12) is located.

6. The accelerometer (2) as claimed in any preceding claim, wherein each of the respective gaps between the fixed (46, 48) and moveable (50, 52) capacitive electrode fingers is substantially equal.

7. The accelerometer (2) as claimed in any preceding claim, further comprising a pulse width modulation (PWM) generator (56) arranged to generate in-phase and anti-phase PWM drive signals with a drive frequency, wherein said in-phase and anti-phase PWM drive signals are applied to the first and second fixed capacitor electrodes (42, 44) respectively such that they are charged alternately.

8. The accelerometer (2) as claimed in any preceding claim, wherein the first and second sets of moveable capacitive electrode fingers (50, 52) further comprise electrical pick-off connections arranged to provide a pick-off signal, in use, for sensing an applied acceleration in the out-of-plane sensing direction.

9. The accelerometer (2) as claimed in claim 8, further comprising an output signal detector (58) arranged to detect the pick-off signal from the accelerometer (2) representing a displacement of the proof mass (12) from a null position, wherein the null position is the position of the proof mass (12) relative to the first and second fixed capacitor electrodes (42, 44) when no acceleration is applied.

10. The accelerometer (2) as claimed in any preceding claim, wherein an upper surface of the fixed capacitive electrode fingers (46, 48) is substantially coplanar with an upper surface of the moveable capacitive electrode fingers (50, 52) when the proof mass (12) is in a null position, wherein the null position is the position of the proof mass (12) relative to the first and second fixed capacitor electrodes (42, 44) when no acceleration is applied.

11. A three-axis accelerometer (1) comprising first, second, and third accelerometers (2, 3, 5) all integrated within a single hermetic package, wherein:
the first accelerometer (3) is arranged to measure an applied acceleration in a first accelerometer direction, and the second accelerometer (5) is arranged to measure an applied acceleration in a second accelerometer direction orthogonal to the first accelerometer direction; and
the third accelerometer (2) is arranged to measure an applied acceleration in an out-of-plane sensing direction orthogonal to the first and second accelerometer directions;
wherein the third accelerometer (2) comprises the accelerometer (2) as claimed in any of claims 1 to 10.

12. A method of producing an accelerometer (2) for sensing accelerations in an out-of-plane sensing direction, the method comprising:
performing a blind etching process on a first surface of a silicon substrate (4);
anodically bonding the support (18, 20) to a first surface of a lower glass layer (8);
performing a full depth etching process on a second surface of the silicon substrate (4), said blind etching and full depth etching processes defining a substantially planar proof mass (12) connected to a support (18, 20) by a compliant flexure (14, 16), the proof mass (12) comprising first and second sets of moveable capacitive electrode fingers (50, 52) extending from the proof mass (12) substantially perpendicular to the out-of-plane sensing direction in a first in-plane direction and laterally spaced in a second in-plane direction perpendicular to the out-of-plane sensing direction; and
anodically bonding the second surface of the silicon substrate (4) to an upper glass layer (6), wherein the upper glass layer (6) and lower glass layer (8) form a hermetically sealed container;
wherein the blind etching process comprises:
etching the first set of fixed capacitive electrode fingers (46) such that said first set of fixed capacitive electrode fingers (46) has a thickness less than a thickness of the first set of moveable capacitive electrode fingers (50); and
etching the second set of fixed capacitive electrode fingers (48) such that said second set of fixed capacitive electrode fingers (48) has a thickness greater than a thickness of the second set of moveable capacitive electrode fingers (52).

13. The method as claimed in claim 12, wherein the first set of moveable capacitive electrode fingers (50) are not thinned such that the respective thickness of the first set of moveable capacitive electrode fingers (50) is substantially equal to a respective thickness of the proof mass (12), and/or wherein the second set of fixed capacitive electrode fingers (48) are not thinned such that the respective thickness of the second set of fixed capacitive electrode fingers (48) is substantially equal to a respective thickness of the proof mass (12).

14. The method as claimed in any of claims 12 or 13, further comprising thinning a portion of the first surface of a lower glass layer (8) before anodically bonding the support (18, 20) to the first surface of the lower glass layer (8).

15. The method as claimed in any of claims 12 to 14, further comprising thinning a portion of the first surface of the upper glass layer (6) before anodically bonding it to the silicon substrate.

## Patentansprüche

1. Beschleunigungsmesser (2), umfassend:
eine im Wesentlichen plane Testmasse (12), die an einem feststehenden Substrat (4) mit einem Träger (18, 20) montiert ist, wobei die Testmasse (12) mit dem Träger (18, 20) durch ein nachgiebiges Verformungselement (14, 16) verbunden ist, so dass sie linear in einer ebenenversetzten Erfassungsrichtung als Reaktion auf eine aufgebrachte Beschleunigung beweglich ist;
wobei die Testmasse (12) einen ersten und einen zweiten Satz beweglicher kapazitiver Elektrodenfinger (50, 52) umfasst, die sich von der Testmasse (12) im Wesentlichen senkrecht zur ebenenversetzten Erfassungsrichtung in einer ersten ebenengleichen Richtung und seitlich beabstandet in einer zweiten ebenengleichen Richtung senkrecht zur ebenenversetzten Erfassungsrichtung erstrecken; und
eine erste und eine zweite feststehende Kapazitätselektrode (42, 44), die an dem feststehenden Substrat (4) montiert sind, wobei die erste feststehende Kapazitätselektrode (42) einen ersten Satz feststehender kapazitiver Elektrodenfinger (46) umfasst und die zweite feststehende Kapazitätselektrode (44) einen zweiten Satz feststehender kapazitiver Elektrodenfinger (48) umfasst;
wobei sich der erste und der zweite Satz feststehender kapazitiver Elektrodenfinger (46, 48) in der ersten ebenengleichen Erfassungsrichtung erstrecken und in der zweiten ebenengleichen Erfassungsrichtung seitlich beabstandet sind;
wobei der erste Satz feststehender kapazitiver Elektrodenfinger (46) so ausgelegt ist, dass er mit dem ersten Satz beweglicher kapazitiver Elektrodenfinger (50) der Testmasse (12) verflochten ist und der zweite Satz feststehender kapazitiver Elektrodenfinger (48) so ausgelegt ist, dass er mit dem zweiten Satz beweglicher kapazitiver Elektrodenfinger (52) der Testmasse (12) verflochten ist;
wobei der erste Satz feststehender kapazitiver Elektrodenfinger (46) eine Dicke aufweist, die geringer als eine Dicke des ersten Satzes beweglicher kapazitiver Elektrodenfinger (50) ist; und
wobei der zweite Satz feststehender kapazitiver Elektrodenfinger (48) eine Dicke aufweist, die größer als eine Dicke des zweiten Satzes beweglicher kapazitiver Elektrodenfinger (52) ist.

2. Beschleunigungsmesser (2) nach Anspruch 1, wobei die Dicke des ersten Satzes (50) und/oder des zweiten Satzes (52) beweglicher kapazitiver Elektrodenfinger im Wesentlichen gleich einer Dicke der Testmasse (12) ist.

3. Beschleunigungsmesser (2) nach Anspruch 1 oder 2, wobei die Testmasse (12) einen beweglichen Rahmen (54) umfasst, der den ersten und den zweiten Satz beweglicher kapazitiver Elektrodenfinger (50, 52) und den ersten und den zweiten Satz feststehender kapazitiver Elektrodenfinger (46, 48) umschließt.

4. Beschleunigungsmesser (2) nach einem der vorstehenden Ansprüche, wobei die Testmasse (12) an dem feststehenden Substrat (4) durch eine Vielzahl von Trägern (18, 20) montiert ist, wobei die Testmasse (12) mit den Trägern (18, 20) durch eine Vielzahl von nachgiebigen Verformungselementen (14, 16) verbunden ist.

5. Beschleunigungsmesser (2) nach einem der vorstehenden Ansprüche, wobei die Testmasse (12) zwischen einer unteren Glasschicht (8) und einer oberen Glasschicht (6) angeordnet ist, wobei die untere und die obere Glasschicht (6, 8) vorzugsweise einen hermetisch abgedichteten Behälter bilden, in dem die Testmasse (12) angeordnet ist.

6. Beschleunigungsmesser (2) nach einem der vorstehenden Ansprüche, wobei jede der jeweiligen Lücken zwischen den feststehenden (46, 48) und den beweglichen (50, 52) kapazitiven Elektrodenfingern im Wesentlichen gleich ist.

7. Beschleunigungsmesser (2) nach einem der vorstehenden Ansprüche, ferner einen Pulsweitenmodulations(PWM)-Generator (56) umfassend, der so ausgelegt ist, dass er gleichphasige und gegenphasige PWM-Antriebssignale mit einer Antriebsfrequenz erzeugt, wobei die gleichphasigen und gegenphasigen PWM-Antriebssignale auf die erste beziehungsweise die zweite feststehende Kapazitätselektrode (42, 44) so aufgebracht werden, dass sie abwechselnd geladen werden.

8. Beschleunigungsmesser (2) nach einem der vorstehenden Ansprüche, wobei der erste und der zweite Satz beweglicher kapazitiver Elektrodenfinger (50, 52) ferner elektrische Abgreifverbindungen umfassen, die so ausgelegt sind, dass sie, bei Betrieb, ein Abgreifsignal zum Erfassen einer aufgebrachten Beschleunigung in der ebenenversetzten Erfassungsrichtung bereitstellen.

9. Beschleunigungsmesser (2) nach Anspruch 8, ferner einen Ausgangssignaldetektor (58) umfassend, der so ausgelegt ist, dass er das Abgreifsignal von dem Beschleunigungsmesser (2) erkennt, das eine Verschiebung der Testmasse (12) von einer Nullposition darstellt, wobei die Nullposition die Position der Testmasse (12) relativ zu der ersten und der zweiten feststehenden Kapazitätselektrode (42, 44) ist, in der keine Beschleunigung aufgebracht wird.

10. Beschleunigungsmesser (2) nach einem der vorstehenden Ansprüche, wobei eine obere Fläche der feststehenden kapazitiven Elektrodenfinger (46, 48) im Wesentlichen koplanar mit einer oberen Fläche der beweglichen kapazitiven Elektrodenfinger (50, 52) ist, wenn sich die Testmasse (12) in einer Nullposition befindet, wobei die Nullposition die Position der Testmasse (12) relativ zu der ersten und der zweiten feststehenden Kapazitätselektrode (42, 44) ist, in der keine Beschleunigung aufgebracht wird.

11. Dreiachsenbeschleunigungsmesser (1), einen ersten, zweiten und dritten Beschleunigungsmesser (2, 3, 5) umfassend, die alle innerhalb eines einzigen hermetischen Pakets integriert sind, wobei:
der erste Beschleunigungsmesser (3) so ausgelegt ist, dass er eine aufgebrachte Beschleunigung in einer ersten Beschleunigungsmesserrichtung misst, und der zweite Beschleunigungsmesser (5) so ausgelegt ist, dass er eine aufgebrachte Beschleunigung in einer zweiten Beschleunigungsmesserrichtung orthogonal zur ersten Beschleunigungsmesserrichtung misst; und
der dritte Beschleunigungsmesser (2) so ausgelegt ist, dass er eine aufgebrachte Beschleunigung in einer ebenenversetzten Erfassungsrichtung orthogonal zur ersten und zweiten Beschleunigungsmesserrichtung misst;
wobei der dritte Beschleunigungsmesser (2) den Beschleunigungsmesser (2) nach einem der Ansprüche 1 bis 10 umfasst.

12. Verfahren zum Herstellen eines Beschleunigungsmessers (2) zum Erfassen von Beschleunigungen in einer ebenenversetzten Erfassungsrichtung, wobei das Verfahren Folgendes umfasst:
Durchführen eines Blindätzvorgangs an einer ersten Oberfläche eines Siliciumsubstrats (4);
anodisches Bonden des Trägers (18, 20) an eine erste Oberfläche einer unteren Glasschicht (8);
Durchführen eines Ätzvorgangs mit vollständiger Tiefe an einer zweiten Oberfläche des Siliciumsubstrats (4), wobei die Vorgänge des Blindätzens und des Ätzens mit vollständiger Tiefe eine im Wesentlichen plane Testmasse (12) definieren, die mit einem Träger (18, 20) durch ein nachgiebiges Verformungselement (14, 16) verbunden ist, wobei die Testmasse (12) einen ersten und einen zweiten Satz beweglicher kapazitiver Elektrodenfinger (50, 52) umfasst, die sich von der Testmasse (12) im Wesentlichen senkrecht zur ebenenversetzten Erfassungsrichtung in einer ersten ebenengleichen Richtung und seitlich beabstandet in einer zweiten ebenengleichen Richtung senkrecht zur ebenenversetzten Erfassungsrichtung erstrecken; und
anodisches Bonden der zweiten Oberfläche des Siliciumsubstrats (4) an eine obere Glasschicht (6), wobei die obere Glasschicht (6) und die untere Glasschicht (8) einen hermetisch abgedichteten Behälter bilden;
wobei der Blindätzvorgang Folgendes umfasst:
Ätzen des ersten Satzes feststehender kapazitiver Elektrodenfinger (46), so dass der erste Satz feststehender kapazitiver Elektrodenfinger (46) eine Dicke aufweist, die geringer als die Dicke des ersten Satzes beweglicher kapazitiver Elektrodenfinger (50) ist; und
Ätzen des zweiten Satzes feststehender kapazitiver Elektrodenfinger (48), so dass der zweite Satz feststehender kapazitiver Elektrodenfinger (48) eine Dicke aufweist, die größer als die Dicke des zweiten Satzes beweglicher kapazitiver Elektrodenfinger (52) ist.

13. Verfahren nach Anspruch 12, wobei der erste Satz beweglicher kapazitiver Elektrodenfinger (50) nicht dünner gemacht werden, so dass die jeweilige Dicke des ersten Satzes beweglicher kapazitiver Elektrodenfinger (50) im Wesentlichen gleich einer jeweiligen Dicke der Testmasse (12) ist, und/oder wobei der zweite Satz feststehender kapazitiver Elektrodenfinger (48) nicht dünner gemacht werden, so dass die jeweilige Dicke des zweiten Satzes feststehender kapazitiver Elektrodenfinger (48) im Wesentlichen gleich einer jeweiligen Dicke der Testmasse (12) ist.

14. Verfahren nach einem der Ansprüche 12 oder 13, ferner das Dünnermachen eines Abschnitts der ersten Oberfläche einer unteren Glasschicht (8) vor dem anodischen Bonden des Trägers (18, 20) an die erste Oberfläche der unteren Glasschicht (8) umfassend.

15. Verfahren nach einem der Ansprüche 12 bis 14, ferner das Dünnermachen eines Abschnitts der ersten Oberfläche der oberen Glasschicht (6) vor ihrem anodischen Bonden an das Siliciumsubstrat umfassend.

## Revendications

1. Accéléromètre (2) comprenant :
une masse d'épreuve (12) sensiblement plane montée sur un substrat fixe (4) au moyen d'un support (18, 20), ladite masse d'épreuve (12) étant reliée au support (18, 20) par une flexion souple (14, 16) de manière à pouvoir se déplacer linéairement dans une direction de détection hors-plan en réponse à une accélération appliquée ;
la masse d'épreuve (12) comprenant des premier et second ensembles de doigts d'électrode capacitive mobiles (50, 52) s'étendant depuis la masse d'épreuve (12) de manière sensiblement perpendiculaire à la direction de détection hors-plan dans une première direction dans le plan et espacés latéralement dans une seconde direction dans le plan perpendiculaire à la direction de détection hors-plan ; et
des première et seconde électrodes de condensateur fixes (42, 44) montées sur le substrat fixe (4), la première électrode de condensateur fixe (42) comprenant un premier ensemble de doigts d'électrode capacitive fixes (46) et la seconde électrode de condensateur fixe (44) comprenant un second ensemble de doigts d'électrode capacitive fixes (48) ; dans lequel les premier et second ensembles de doigts d'électrode capacitive fixes (46, 48) s'étendent dans la première direction de détection dans le plan et sont espacés latéralement dans la seconde direction de détection dans le plan ;
dans lequel le premier ensemble de doigts d'électrode capacitive fixes (46) est agencé pour s'intercaler avec le premier ensemble de doigts d'électrode capacitive mobiles (50) de la masse d'épreuve (12) et le second ensemble de doigts d'électrode capacitive fixes (48) est agencé pour s'intercaler avec le second ensemble de doigts d'électrode capacitive mobiles (52) de la masse d'épreuve (12) ;
dans lequel le premier ensemble de doigts d'électrode capacitive fixes (46) a une épaisseur inférieure à une épaisseur du premier ensemble de doigts d'électrode capacitive mobiles (50) ; et
dans lequel le second ensemble de doigts d'électrode capacitive fixes (48) a une épaisseur supérieure à une épaisseur du second ensemble de doigts d'électrode capacitive mobiles (52).

2. Accéléromètre (2) selon la revendication 1, dans lequel l'épaisseur du premier ensemble (50) et/ou du second ensemble (52) de doigts d'électrode capacitive mobiles est sensiblement égale à une épaisseur de la masse d'épreuve (12).

3. Accéléromètre (2) selon la revendication 1 ou 2, dans lequel la masse d'épreuve (12) comprend un châssis mobile (54) qui renferme les premier et second ensembles de doigts d'électrode capacitive mobiles (50, 52) et les premier et second ensembles de doigts d'électrode capacitive fixes (46, 48).

4. Accéléromètre (2) selon une quelconque revendication précédente, dans lequel la masse d'épreuve (12) est montée sur le substrat fixe (4) au moyen d'une pluralité de supports (18, 20), la masse d'épreuve (12) étant reliée aux supports (18, 20) par une pluralité de flexions souples (14, 16).

5. Accéléromètre (2) selon une quelconque revendication précédente, dans lequel la masse d'épreuve (12) est située entre une couche de verre inférieure (8) et une couche de verre supérieure (6), dans lequel les couches de verre inférieure et supérieure (6, 8) forment de préférence un contenant hermétiquement fermé dans lequel se trouve la masse d'épreuve (12) .

6. Accéléromètre (2) selon une quelconque revendication précédente, dans lequel chacun des espaces respectifs entre les doigts d'électrode capacitive fixes (46, 48) et mobiles (50, 52) est sensiblement égal.

7. Accéléromètre (2) selon une quelconque revendication précédente, comprenant en outre un générateur à modulation de largeur d'impulsion (PWM) (56) agencé pour générer des signaux de commande PWM en phase et anti-phase avec une fréquence de commande, dans lequel lesdits signaux de commande PWM en phase et anti-phase sont appliqués respectivement aux première et seconde électrodes de condensateur fixes (42, 44) de sorte qu'elles sont chargées en alternance.

8. Accéléromètre (2) selon une quelconque revendication précédente, dans lequel les premier et second ensembles de doigts d'électrode capacitive mobiles (50, 52) comprennent en outre des liaisons de capteurs électriques agencées pour fournir un signal de capteur, lors de l'utilisation, pour détecter une accélération appliquée dans la direction de détection hors-plan.

9. Accéléromètre (2) selon la revendication 8, comprenant en outre un détecteur de signal de sortie (58) agencé pour détecter le signal de capteur provenant de l'accéléromètre (2) représentant un déplacement de la masse d'épreuve (12) à partir d'une position nulle, dans lequel la position nulle est la position de la masse d'épreuve (12) par rapport aux première et seconde électrodes de condensateur fixes (42, 44) lorsqu'aucune accélération n'est appliquée.

10. Accéléromètre (2) selon une quelconque revendication précédente, dans lequel une surface supérieure des doigts d'électrode capacitive fixes (46, 48) est sensiblement coplanaire avec une surface supérieure des doigts d'électrode capacitive mobiles (50, 52) lorsque la masse d'épreuve (12) est dans une position nulle, dans lequel la position nulle est la position de la masse d'épreuve (12) par rapport aux première et seconde électrodes de condensateur fixes (42, 44) lorsqu'aucune accélération n'est appliquée.

11. Accéléromètre à trois axes (1) comprenant des premier, deuxième et troisième accéléromètres (2, 3, 5) tous intégrés à l'intérieur d'un seul boîtier hermétique, dans lequel :
le premier accéléromètre (3) est conçu pour mesurer une accélération appliquée dans une première direction d'accéléromètre, et le deuxième accéléromètre (5) est conçu pour mesurer une accélération appliquée dans une seconde direction d'accéléromètre perpendiculaire à la première direction d'accéléromètre ; et
le troisième accéléromètre (2) est conçu pour mesurer une accélération appliquée dans une direction de détection hors-plan perpendiculaire aux première et seconde directions d'accéléromètre ;
dans lequel le troisième accéléromètre (2) comprend l'accéléromètre (2) selon l'une quelconque des revendications 1 à 10.

12. Procédé de production d'un accéléromètre (2) permettant de détecter des accélérations dans une direction de détection hors-plan, le procédé comprenant :
l'exécution d'un processus de gravure aveugle sur une première surface d'un substrat de silicium (4) ;
la liaison anodique du support (18, 20) avec une première surface d'une couche de verre inférieure (8) ;
l'exécution d'un processus de gravure pleine profondeur sur une seconde surface du substrat de silicium (4), lesdits processus de gravure aveugle et de gravure pleine profondeur définissant une masse d'épreuve (12) sensiblement plane reliée à un support (18, 20) par une flexion souple (14, 16), la masse d'épreuve (12) comprenant des premier et second ensembles de doigts d'électrode capacitive mobiles (50, 52) s'étendant depuis la masse d'épreuve (12) de manière sensiblement perpendiculaire à la direction de détection hors-plan dans une première direction dans le plan et espacés latéralement dans une seconde direction dans le plan perpendiculaire à la direction de détection hors-plan ; et
la liaison anodique de la seconde surface du substrat de silicium (4) avec une couche de verre supérieure (6), dans lequel la couche de verre supérieure (6) et la couche de verre inférieure (8) forment un contenant hermétiquement fermé ;
dans lequel le processus de gravure aveugle comprend :
la gravure du premier ensemble de doigts d'électrode capacitive fixes (46) de sorte que ledit premier ensemble de doigts d'électrode capacitive fixes (46) a une épaisseur inférieure à une épaisseur du premier ensemble de doigts d'électrode capacitive mobiles (50) ; et
la gravure du second ensemble de doigts d'électrode capacitive fixes (48) de sorte que ledit second ensemble de doigts d'électrode capacitive fixes (48) a une épaisseur supérieure à une épaisseur du second ensemble de doigts d'électrode capacitive mobiles (52).

13. Procédé selon la revendication 12, dans lequel le premier ensemble de doigts d'électrode capacitive mobiles (50) ne sont pas amincis de sorte que l'épaisseur respective du premier ensemble de doigts d'électrode capacitive mobiles (50) est sensiblement égale à une épaisseur respective de la masse d'épreuve (12), et/ou dans lequel le second ensemble de doigts d'électrode capacitive fixes (48) ne sont pas amincis de sorte que l'épaisseur respective du second ensemble de doigts d'électrode capacitive fixes (48) est sensiblement égale à une épaisseur respective de la masse d'épreuve (12).

14. Procédé selon l'une quelconque des revendications 12 ou 13, comprenant en outre l'amincissement d'une partie de la première surface d'une couche de verre inférieure (8) avant la liaison anodique du support (18, 20) avec la première surface de la couche de verre inférieure (8).

15. Procédé selon l'une quelconque des revendications 12 à 14, comprenant en outre l'amincissement d'une partie de la première surface de la couche de verre supérieure (6) avant la liaison anodique de celle-ci avec le substrat de silicium.
